(19) Europäisches Patentamt
European Patent Office
Office européen des brevets

(11) **EP 3 792 987 A1**

(12) **EUROPEAN PATENT APPLICATION**

(43) Date of publication:
**17.03.2021 Bulletin 2021/11**

(51) Int Cl.:
***H01L 35/16*** *(2006.01)*      ***H01L 35/26*** *(2006.01)*

(21) Application number: **20194066.5**

(22) Date of filing: **02.09.2020**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **12.09.2019 JP 2019166126**

(71) Applicant: **Panasonic Corporation
Osaka 571-8501 (JP)**

(72) Inventors:
• **TAKAHASHI, Misato
Osaka, 540-6207 (JP)**
• **TANAKA, Junya
Osaka, 540-6207 (JP)**
• **KUROSAKI, Ken
Kyoto 606-8501 (JP)**

(74) Representative: **Eisenführ Speiser
Patentanwälte Rechtsanwälte PartGmbB
Postfach 10 60 78
28060 Bremen (DE)**

(54) **THERMOELECTRIC CONVERSION MATERIAL**

(57) An object of the present disclosure is to improve a Seebeck coefficient S without depending on a carrier concentration n in a thermoelectric conversion material.

The thermoelectric conversion material that achieves the above object includes a mother phase containing a Bi-Te based material, and a second phase which is disposed so as to be dispersed in the mother phase and which forms an energy barrier having a height of 0.05 eV or more and 0.2 eV or less with respect to the conduction band of the Bi-Te based material.

FIG. 3

**Description**

Technical Field

The present disclosure relates to thermoelectric conversion materials.

Background Art

A thermoelectric conversion material is capable of directly converting heat into electricity, or of heating and cooling by application of electricity. A p-type thermoelectric conversion material and an n-type thermoelectric conversion material are combined to form a thermoelectric conversion device.

The property of a thermoelectric conversion material is evaluated by the figure of merit Z (unit: /K). The figure of merit Z is represented by the following equation (1) using Seebeck coefficient S (unit: V/K), thermal conductivity $\kappa$ (unit: W/m·K), and electrical conductivity $\sigma$ (unit: /Ω·m).
[Equation 1]

$$Z = S^2 \sigma / \kappa \ldots (1)$$

The property of a thermoelectric conversion material may also be evaluated by the product of the figure of merit Z and temperature T. In this case, both sides of the equation (1) are multiplied by absolute temperature T to obtain the following equation (2).
[Equation 2]

$$ZT = S^2 \sigma T / \kappa \ldots (2)$$

ZT obtained by the above equation (2) is referred to as a dimensionless figure of merit ZT and is a suitable index showing the performance of a thermoelectric conversion material. A thermoelectric conversion material having a greater value of ZT shows a higher thermoelectric performance at the absolute temperature T. On the basis of the above equations (1) and (2), an excellent thermoelectric conversion material means a material having an increased value of the dimensionless figure of merit ZT, that is, a material having large Seebeck coefficient S and electrical conductivity $\sigma$, and a small thermal conductivity $\kappa$.

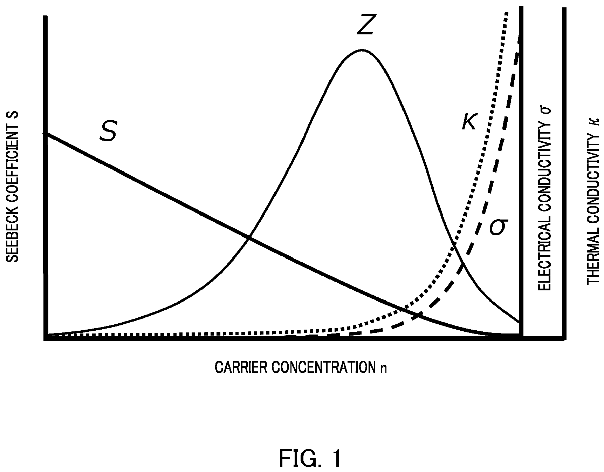

FIG. 1 shows the relationship of Seebeck coefficient S, electrical conductivity $\sigma$ and thermal conductivity $\kappa$ with carrier concentration n in a generally used thermoelectric conversion material. In FIG. 1, the ordinate represents the Seebeck coefficient S, electrical conductivity $\sigma$, and thermal conductivity $\kappa$, and the abscissa represents the carrier concentration n (unit: /cm$^3$) of a thermoelectric conversion material. The carrier concentration n is the number of electrons or holes contained in a semiconductor per volume. As shown in FIG. 1, the Seebeck coefficient S and electrical conductivity $\sigma$ normally change depending on the carrier concentration n. In addition, there is a trade-off between the dependences of the Seebeck coefficient S and the electrical conductivity $\sigma$ on the carrier concentration n. The decrease of the carrier concentration n can increase the Seebeck coefficient S, but at the same time, decreases the electrical conductivity $\sigma$.

FIG. 1 also shows the figure of merit Z calculated by the above equation (1). In a generally used thermoelectric conversion material, the figure of merit Z has a maximum value at a certain carrier concentration n as shown in FIG. 1. In order to maximize the figure of merit Z in a generally used thermoelectric conversion material, it is necessary to adjust the carrier concentration n to an optimum value. The carrier concentration n can be easily adjusted by changing the composition ratio of the thermoelectric conversion material components or by doping with an element that becomes an anion such as iodine, however, a dramatic improvement of the figure of merit Z cannot be expected with such a method.

Bi-Te based thermoelectric conversion materials are in practical use. Bi-Te based thermoelectric conversion materials have been developed mainly for use in a low temperature range. However, since the discovery in the 1960s, no dramatic improvement in performance has been achieved.

In recent years, efforts are being made to improve the figure of merit Z by disposing nanoparticles 101 in mother phase (matrix) 102 composed of thermoelectric conversion material 100 as shown in the schematic cross-sectional view of FIG. 2 (Patent Literature (hereinafter, abbreviated as PTL) 1). Reference numeral 103 in FIG. 2 refers to a sapphire substrate on which a plurality of raw material elements of the thermoelectric conversion material is to be layered by a molecular beam epitaxy method.

The technique of PTL 1 can enhance the scattering of lattice vibration in the crystal of thermoelectric conversion material 100 due to the presence of nanoparticles 101. The technique thus can reduce thermal conductivity $\kappa$ to improve the figure of merit Z in the equation (1) as a result.

Citation List

Patent Literature

PTL 1
WO2018/225374

Summary of Invention

Technical Problem

In the conventional configuration disclosed in PTL 1, only the reduction of the thermal conductivity $\kappa$ is

discussed as a means for improving the figure of merit Z. The technique in PTL 1 does not properly select mother phase 102 and nanoparticles 101 that cause scattering of low energy carriers. The technique unfortunately cannot improve the Seebeck coefficient S, which contributes the most (squared contribution) to the figure of merit Z.

The present disclosure is capable of improving the Seebeck coefficient. Specifically, an object of the present disclosure is to provide a thermoelectric conversion material whose Seebeck coefficient is improved without depending on the carrier concentration in the thermoelectric conversion material, resulting in dramatically improved performance.

Solution to Problem

To improve the Seebeck coefficient, a thermoelectric conversion material of the present disclosure includes a mother phase containing a Bi-Te based material, and a second phase which is disposed so as to be dispersed in the mother phase and which forms an energy barrier having a height of 0.05 eV or more and 0.2 eV or less with respect to the conduction band of the Bi-Te based material.

Advantageous Effects of Invention

The thermoelectric conversion material of the present disclosure is capable of improving Seebeck coefficient without depending on the carrier concentration in the thermoelectric conversion material due to the expression of an energy filtering effect.

Brief Description of Drawings

FIG. 1 shows the relationship of Seebeck coefficient S, electrical conductivity $\sigma$ and thermal conductivity $\kappa$ with carrier concentration n in a generally used thermoelectric conversion material, and shows figure of merit Z of the thermoelectric conversion material;

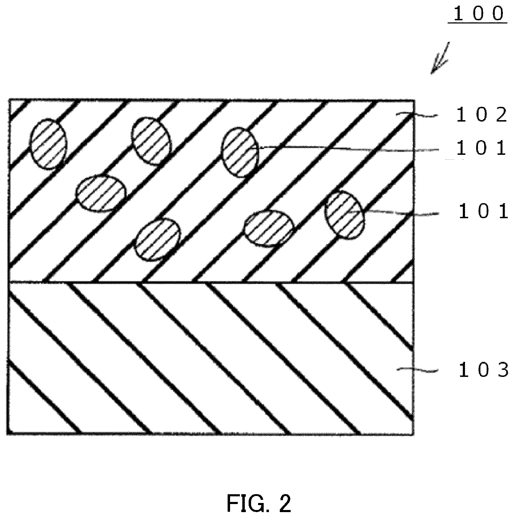

FIG. 2 schematically illustrates a conventional thermoelectric conversion material described in PTL 1;

FIG. 3 schematically illustrates a thermoelectric conversion material in an embodiment of the present disclosure;

FIG. 4 shows a spectrum obtained by XRD measurement of a thermoelectric conversion material of Example 1 of the present disclosure, and individual spectra of values of $Bi_2Te_3$, $AuTe_2$ and Au in literatures;

FIG. 5 shows a mapping result of Au by EDX analysis of the surface of the thermoelectric conversion material of Example 1 of the present disclosure;

FIG. 6 shows the relationship between the Seebeck coefficient S and the carrier concentration n in Examples 1 to 3 and Comparative Example 1 of the present disclosure;

FIG. 7 shows the relationship between the Seebeck coefficient S and the electrical resistivity $\rho$ in Examples 1 to 3 and Comparative Example 1 of the present disclosure; and

FIG. 8 schematically illustrates an energy band of the thermoelectric conversion material of the embodiment of the present disclosure.

Description of Embodiments

Hereinafter, an embodiment of the present disclosure will be described with reference to the drawings.

(Embodiment)

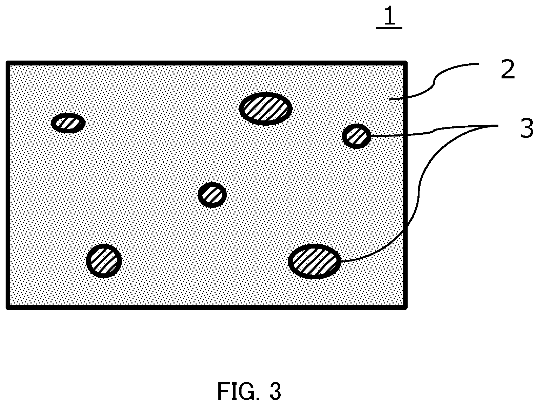

FIG. 3 schematically illustrates thermoelectric conversion material 1 in an embodiment of the present disclosure. Thermoelectric conversion material 1 of the present embodiment includes mother phase 2 and second phase 3 as shown in FIG. 3.

Mother phase 2 is a thermoelectric conversion material that mainly contains a Bi-Te based material, and may be a P-type thermoelectric conversion material or an N-type thermoelectric conversion material. The Bi-Te based material constituting mother phase 2 contains Bi and Te, and may be composed of Bi and Te, such as $Bi_2Te_3$. The Bi-Te based material may contain at least one element, for example, Sb, Se, Al, Mn, Fe, Cr, Mo, Ga, Sn, Zn, P or Si in addition to Bi and Te. Inclusion of, for example, Sb or Se in addition to Bi and Te may increase the reliability of thermoelectric conversion material 1.

Examples of the Bi-Te based materials containing Sb and Se include $Bi_xSb_{2-x}Te_3$ (x is from 0.1 to 0.6), which is a solid solution of $Bi_2Te_3$ and $Sb_2Te_3$, and $Bi_2Te_{3-x}Se_x$ (x is from 0.05 to 0.25), which is a solid solution of $Bi_2Te_3$ and $Bi_2Se_3$. $Bi_xSb_{2-x}Te_3$ serves as a P-type thermoelectric conversion material, and $Bi_2Te_{3-x}Se_x$ serves as an N-type thermoelectric conversion material.

The Bi-Te based material may contain a halogen element such as I, Cl or Br as a dopant. The amount of the halogen element in the Bi-Te based material can be set to about 0.01 to 5 mass% based on the total amount of the Bi-Te based material.

Second phase 3 contains a material that forms an energy barrier having a height of 0.05 eV or more and 0.2 eV or less with respect to the conduction band of the Bi-Te based material in mother phase 2. Second phase 3 preferably contains at least one metal selected from the group consisting of, for example, Au, Pb, Cu, Ni, W and Pt. Second phase 3 may contain the metal as a single substance (single metal, i.e., the metal only), or as a compound in which the metal and an element other than the metal are bonded. Examples of the other elements bonding to the metal include Bi, Te, Se, Sb and other metals. As seen in the detailed description for the energy barrier below, the conduction band of the Bi-Te based material and the energy barrier of second phase 3 can be specified by determining the band structure of thermoelectric conversion material 1 by angle-resolved photoelectron spectroscopy measurement.

Second phase 3 is disposed so as to be dispersed in mother phase 2. When second phase 3 is disposed in a uniformly dispersed manner in mother phase 2, it becomes possible to selectively scatter low energy carriers as will be described below, thus infallibly causing an energy filtering effect (improvement of Seebeck coefficient S). Second phase 3 may be dispersed in mother phase 2 in any state as long as the effects of the present embodiment is not impaired, and is preferably in a form of particles whose size is preferably 10 $\mu$m or less. The particle size is more preferably 1 $\mu$m or less, and particularly preferably in the order of nm (nanometer). Second phase 3 having a particle size of 10 $\mu$m or less can sufficiently increase the Seebeck coefficient S of thermoelectric conversion material 1 as described below. The particle size of second phase 3 is measured by an X-ray diffraction method. More specifically, the particle size can be specified from the half-width of the peak of second phase 3 in the measurement result of the X-ray diffraction method.

The amount of second phase 3 in thermoelectric conversion material 1 is preferably 0.5 to 10.0 at% based on the total amount (at%) of mother phase 2. Second phase 3 having an amount of 0.5 at% or more can sufficiently increase the Seebeck coefficient S of thermoelectric conversion material 1 as described below. Second phase 3 having an amount of 10.0 at% or less, meanwhile, is less likely to reduce the performance of mother phase 2. The amount of second phase 3 can be specified by an elemental analysis or the like of thermoelectric conversion material 1.

Thermoelectric conversion material 1 of the present embodiment may be prepared by sufficiently mixing a pulverized product of a Bi-Te based material constituting mother phase 2 and a material constituting second phase 3, and sintering the mixture by a known method. A solvent, such as ethanol, may be used as necessary. The method for preparing thermoelectric conversion material 1 is not limited to the above method.

Examples

Examples will be shown below to specifically describe the thermoelectric conversion materials in the above embodiment. Hereinafter, as an example, a method for producing a Bi-Te-Se-Au based thermoelectric conversion material, which exhibits N-type properties, by using SPS (discharge plasma) sintering process and the thermoelectric conversion performance of the produced thermoelectric conversion material will be described.

(Example 1)

A Bi-Te based material starting from single metals of Bi, Te and Se was used for the mother phase. Specifically, pure metals Bi, Te and Se were placed in a carbon crucible at an atomic ratio of Bi: Te: Se = 2: 2.8: 0.2. In an inert gas atmosphere, a melting and stirring furnace was then used to heat up to a maximum temperature of 700°C to melt the metals, and the molten metals were kept for 5 hours. Subsequently, the inside of the furnace was naturally cooled and the resulting ingot was taken out. Au was selected as an element for the second phase. Au nanoparticles were added in an amount of 1.5 at% based on the total amount of the pulverized ingot. The mixture was mixed and pulverized for 12 hours with a ball mill. The resulting powder was put into a beaker together with ethanol, and irradiated with ultrasonic waves for 1 hour, thus further mixing and dispersing the Bi-Te-Se powder and the Au nanoparticles. The ethanol and powder were then heated with a heater to remove ethanol. The obtained dry powder was SPS-sintered at a temperature of 350°C and a pressure of 60 MPa under an Ar atmosphere for 5 minutes to prepare a thermoelectric conversion material.

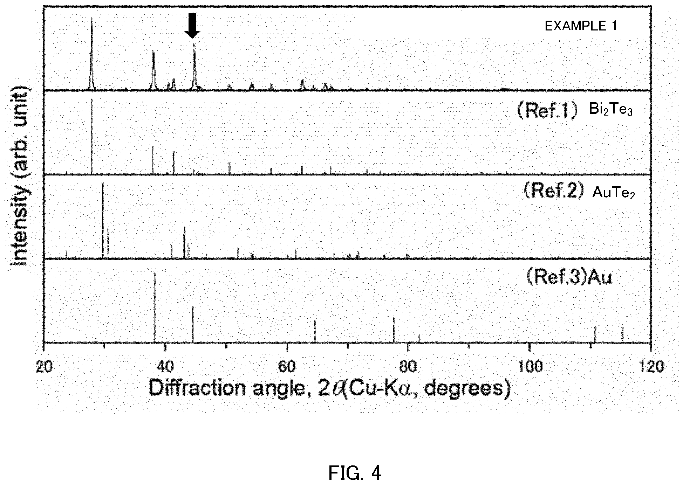

FIG. 4 shows the XRD (X-ray diffraction) measurement result of the produced thermoelectric conversion material of Example 1, and individual spectra of values of $Bi_2Te_3$, AuTe2 and single Au in literatures (hereinafter, each is also referred to as "literature value spectrum"). In each graph, the ordinate represents the diffracted X-ray intensity and the abscissa represents the measurement degrees. The spectrum of the produced thermoelectric conversion material of Example 1 is in good coincidence with the literature value spectrum of Bi2Te3, and a Bi-Te based material, namely the mother phase, is recognized to be produced. Further, the peak at the degree indicated by the arrow coincides with the literature value spectrum of single Au, thus indicating that the desired thermoelectric conversion material containing the second phase composed of Au was obtained.

Table 1 below shows the atomic number concentration of each element on the surface of the thermoelectric conversion material of Example 1 when the thermoelectric conversion material was subjected to EDX analysis. Table 1 shows that, as the results of the XRD analysis does, Au is indeed contained.

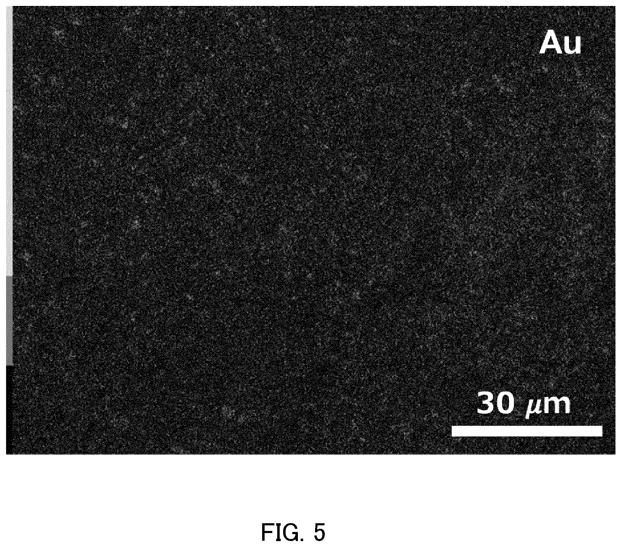

FIG. 5 shows a mapping result of Au by EDX analysis of the surface of the produced thermoelectric conversion material 1. In FIG. 5, white parts represent the presence of Au. This result shows that Au (second phase) is present in the thermoelectric conversion material in a well dispersed state without segregation.

[Table 1]

| Element | Atomic number concentration (%) |
| --- | --- |
| Bi | 40.95 |

(continued)

| Element | Atomic number concentration (%) |
|---------|-------------------------------|
| Te | 53.16 |
| Se | 3.61 |
| Au | 2.28 |

(Example 2)

A thermoelectric conversion material was produced in the same manner as in Example 1, except that Au nanoparticles were added in an amount of 3.0 at% based on the total amount of the pulverized ingot of the Bi-Te based material.

(Example 3)

A thermoelectric conversion material was produced in the same manner as in Example 1, except that Au nanoparticles were added in an amount of 5.0 at% based on the total amount of the pulverized ingot of the Bi-Te based material.

(Comparative Example 1)

Comparative Example 1 was made in the same manner as Examples 1 to 3, except that no element of the second phase (Au of the present embodiment) was added, thus producing a Bi-Te based thermoelectric conversion material having only the mother phase of the present embodiment.

(Evaluation)

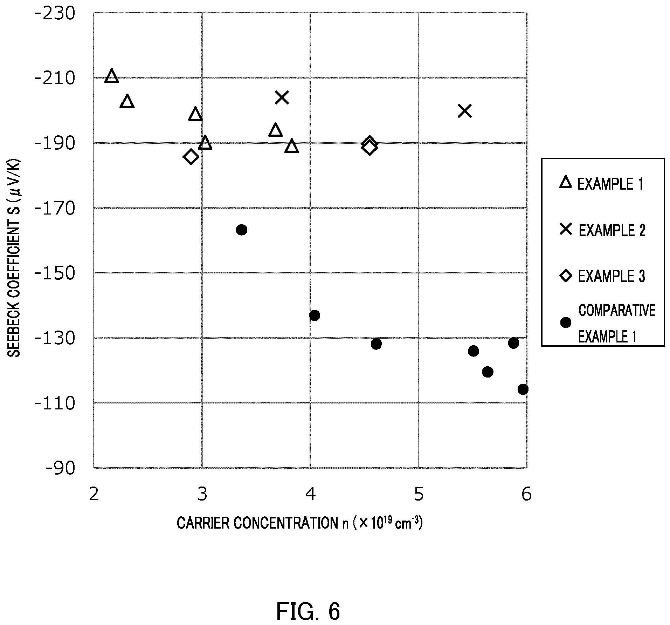

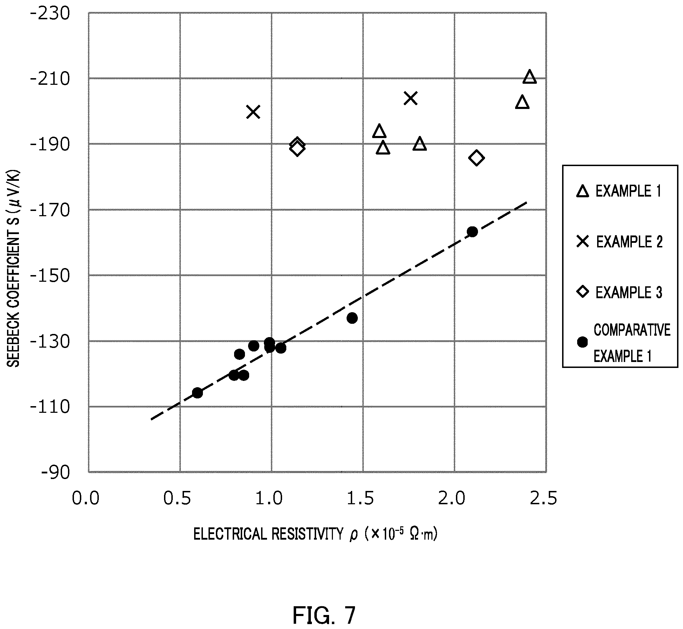

The thermoelectric conversion materials of Examples 1 to 3 and Comparative Example 1 were molded into a rectangular parallelepiped shape, and a Seebeck coefficient S and an electrical resistivity $\rho$ (unit: $\Omega \cdot m$) that is the reciprocal of the electrical conductivity $\sigma$ were measured at room temperature with a thermoelectric performance evaluation device. The thermoelectric conversion materials of Examples 1 to 3 and Comparative Example 1 were also molded into a disk shape, and a Hall effect measurement was performed to measure the carrier concentration n. FIGS. 6 and 7 show the performance measurement results of Examples 1 to 3 and Comparative Example 1.

FIG. 6 shows measurement results of Examples 1 to 3 and Comparative Example 1 for the Seebeck coefficient S measured with the thermoelectric performance evaluation device and the carrier concentration n obtained by the Hall effect measurement. In FIG. 6, the ordinate represents the Seebeck coefficient S on the inversion axis, and the abscissa represents the carrier concentration n. As shown in FIG. 6, the absolute value of the Seebeck coefficient S increases as the carrier concentration n decreases in Comparative Example 1, and this trend coincides with the dependence of a general Seebeck coefficient S on the carrier concentration n. In Examples 1 to 3, meanwhile, the dependence of the Seebeck coefficient S on the carrier concentration n is very small. This small dependence is presumably resulting from the fact that the carrier concentration n contributing to the thermoelectric conversion effect became smaller than the carrier concentration n obtained by the Hall effect measurement due to the expression of the energy filtering effect described below. Examples 1 to 3 generally have a higher Seebeck coefficient S than comparative Example 1 at the same carrier concentration n.

FIG. 7 shows measurement results of Examples 1 to 3 and Comparative Example 1 for the Seebeck coefficient S and electrical resistivity $\rho$ measured with the thermoelectric performance evaluation device. In FIG. 7, the ordinate represents the Seebeck coefficient S on the inversion axis, and the abscissa represents the electrical resistivity $\rho$. As shown in FIG. 7, the Seebeck coefficient S linearly depends on the electrical resistivity $\rho$ in Comparative Example 1, and this trend coincides with the characteristic of a generally used thermoelectric conversion material. Examples 1 to 3, meanwhile, show no obvious dependence of the Seebeck coefficient S on the electrical resistivity $\rho$. In addition, Examples 1 to 3 generally have a higher absolute value of the Seebeck coefficient S than comparative Example 1.

The thermoelectric conversion material of the present embodiment has a higher absolute value of the Seebeck coefficient S than a thermoelectric conversion material containing no second phase (for example, the thermoelectric conversion material of Comparative Example 1) at the same carrier concentration n and electrical resistivity $\rho$. In a generally used thermoelectric conversion material, the Seebeck coefficient S depends on the carrier concentration n, and there is a trade-off between the Seebeck coefficient S and the electrical conductivity $\sigma$. In the thermoelectric conversion material of the present embodiment, meanwhile, the absolute value of the Seebeck coefficient S was improved without depending on the carrier concentration n or the electrical conductivity $\sigma$. This result shows that a thermoelectric conversion material having an improved figure of merit Z in the equation (1) was obtained.

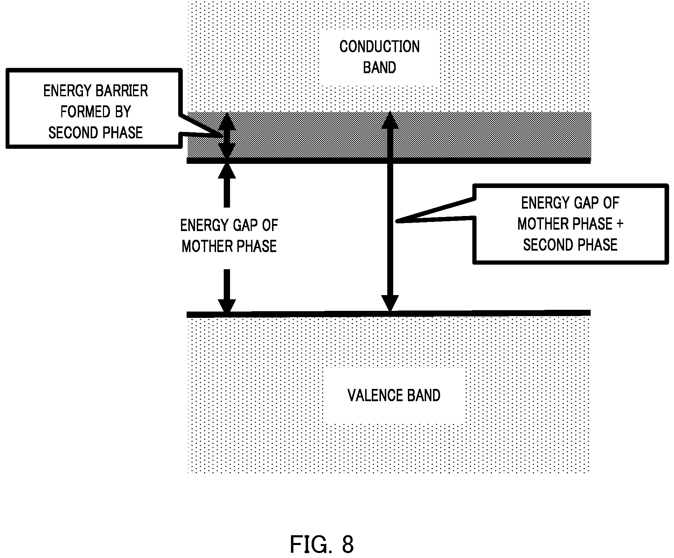

The expression of an energy filtering effect allows for the improvement of the absolute value of the Seebeck coefficient S and the figure of merit Z in the thermoelectric conversion material of the present embodiment. The energy filtering effect will now be described. The presence of a well dispersed second phase having a microsize or less (greatly reduced size) in a mother phase material allows carriers with low energy to be selectively scattered at the boundary between the mother phase and the second phase. If the second phase has a size larger than the microsize, not only low energy carriers but also carriers having high energy are scattered, so that the desired effect cannot be sufficiently obtained. FIG. 8 schematically illustrates an energy band of the thermoelectric conversion material. The introduction of the second phase forms in the conduction band of the mother phase an energy barrier having a height corresponding to the material constituting the second phase, thereby increasing the band gap of the thermoelectric conversion material as a whole by the height of the energy barrier as shown in FIG. 8. Carriers with low energy that cannot exceed the increased energy gap thus do not contribute to the thermoelectric conversion effect. This improves the average energy of carriers that contribute to the thermoelectric conversion effect. The Seebeck coefficient S depends on this average energy value and therefore is improved as a result.

The height of the energy barrier is the difference between the energy height of the conduction band of the mother phase and the work coefficient of the constituent material (metal or compound) of the second phase. Therefore, a specific metal having a work coefficient with an energy barrier having a height of 0.05 eV or more and 0.2 eV or less with respect to the conduction band of the Bi-Te based material, or a compound of the metal and another element should be selected as the constituent material of the second phase. If the height of the energy barrier of the second phase is less than 0.05 eV, the number of low energy carriers that can exceed the energy gap of the entire thermoelectric conversion material becomes too large, and thus the energy average value of the carriers cannot be increased. At the same time, if the height of the energy barrier of the second phase is more than 0.2 eV, the number of carriers that can exceed the energy gap of the entire thermoelectric conversion material becomes too small, and thus the energy average value of the carriers cannot be increased, either.

As is clear from the above results, the Bi-Te based thermoelectric conversion material containing the second phase that forms a specific energy barrier has the Seebeck coefficient S and the figure of merit Z superior to those of conventional Bi-Te based thermoelectric conversion materials.

Similar effects can be obtained when particles of a single metal selected from Pb, Cu, Ni, W and Pt are used for the second phase in place of Au nanoparticles of the above Example. A similar effect can also be obtained with compounds composed of at least one of these metals and another element. The second phase, when it is well dispersed in the thermoelectric conversion material, selectively scatters only low energy carriers, thus infallibly causing an energy filtering effect.

Although the above embodiments have been described in detail with reference to specific compounds in the above examples, the present disclosure is not limited to the above contents, and various modifications and changes can be made in a range not departing from the scope of the present disclosure.

Industrial Applicability

The thermoelectric conversion material of the present disclosure has higher thermoelectric performance than conventional thermoelectric conversion materials, and can be applied to local cooling applications such as Peltier modules and large capacity cooling applications such as refrigerators.

Reference Signs List

1, 100    Thermoelectric conversion material
2, 102    Mother phase
3         Second phase
101       Nanoparticle
103       Sapphire substrate

**Claims**

1.  A thermoelectric conversion material comprising:

    a mother phase containing a Bi-Te based material; and
    a second phase forming an energy barrier having a height of 0.05 eV or more and 0.2 eV or less with respect to a conduction band of the Bi-Te based material, the second phase being disposed so as to be dispersed in the mother phase.

2.  The thermoelectric conversion material according to claim 1, wherein:

    the second phase in the mother phase is disposed in a form of particles; and
    an average particle size of the second phase is 10 $\mu$m or less.

3.  The thermoelectric conversion material according to claim 1 or 2, wherein:
    the second phase contains at least one metal selected from the group consisting of Au, Pb, Cu, Ni, W and Pt.

4.  The thermoelectric conversion material according to claim 3, wherein:
    the second phase contains a metal or contains a compound containing the at least one metal.

FIG. 1

FIG. 2

FIG. 3

FIG. 4

FIG. 5

FIG. 6

FIG. 7

CONDUCTION
BAND

ENERGY BARRIER
FORMED BY
SECOND PHASE

ENERGY GAP OF
MOTHER PHASE

ENERGY GAP OF
MOTHER PHASE +
SECOND PHASE

VALENCE BAND

FIG. 8

Europäisches
Patentamt

European
Patent Office

Office européen
des brevets

# EUROPEAN SEARCH REPORT

Application Number

EP 20 19 4066

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | TRUNG HUU NGUYEN ET AL: "Enhancement of Thermoelectric Properties of Bismuth Telluride Composite with Gold Nano-Particles Inclusions Using Electrochemical Co-Deposition", JOURNAL OF THE ELECTROCHEMICAL SOCIETY, vol. 166, no. 12, 22 July 2019 (2019-07-22), pages D508-D513, XP055770154, ISSN: 0013-4651, DOI: 10.1149/2.1011912jes * the whole document * | 1-4 | INV. H01L35/16 H01L35/26 |
| X | KR 2017 0078949 A (KOREA INST CERAMIC ENG & TECH [KR]) 10 July 2017 (2017-07-10) * paragraph [0028] - paragraph [0042]; figures 1,2 * | 1-4 | |
| X | SAMAT KHAIRUL FADZLI ET AL: "Enhancement in thermoelectric performance of electrochemically deposited platinum-bismuth telluride nanocomposite", ELECTROCHIMICA ACTA, vol. 312, 29 April 2019 (2019-04-29), pages 62-71, XP085695064, ISSN: 0013-4686, DOI: 10.1016/J.ELECTACTA.2019.04.139 * the whole document * | 1-4 | TECHNICAL FIELDS SEARCHED (IPC) H01L |
| A | EP 3 246 959 A1 (LG CHEMICAL LTD [KR]) 22 November 2017 (2017-11-22) * paragraph [0033] - paragraph [0063]; figure 1 * | 1-4 | |

The present search report has been drawn up for all claims

| Place of search | Date of completion of the search | Examiner |
|---|---|---|
| The Hague | 29 January 2021 | Kirkwood, Jonathan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 3 792 987 A1

## ANNEX TO THE EUROPEAN SEARCH REPORT
## ON EUROPEAN PATENT APPLICATION NO.

EP 20 19 4066

This annex lists the patent family members relating to the patent documents cited in the above-mentioned European search report.
The members are as contained in the European Patent Office EDP file on
The European Patent Office is in no way liable for these particulars which are merely given for the purpose of information.

29-01-2021

| Patent document cited in search report | | Publication date | Patent family member(s) | | Publication date |
|---|---|---|---|---|---|
| KR 20170078949 | A | 10-07-2017 | NONE | | |
| EP 3246959 | A1 | 22-11-2017 | CN | 107408618 A | 28-11-2017 |
| | | | EP | 3246959 A1 | 22-11-2017 |
| | | | JP | 6599480 B2 | 30-10-2019 |
| | | | JP | 2018523294 A | 16-08-2018 |
| | | | KR | 20170011159 A | 02-02-2017 |
| | | | US | 2018033939 A1 | 01-02-2018 |
| | | | WO | 2017014583 A1 | 26-01-2017 |

EPO FORM P0459

For more details about this annex : see Official Journal of the European Patent Office, No. 12/82

16

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2018225374 A